Europäisches Patentamt

European Patent Office

Office européen des brevets

(11) Publication number: **0 209 839**
**A2**

## (12) EUROPEAN PATENT APPLICATION

(21) Application number: **86109713.7**

(22) Date of filing: **15.07.86**

(51) Int. Cl.⁴: **H03M 13/12 , H03M 13/00**

(30) Priority: **24.07.85 US 759012**

(43) Date of publication of application:
**28.01.87 Bulletin 87/05**

(84) Designated Contracting States:
**DE FR GB IT**

(71) Applicant: **International Business Machines Corporation**
**Old Orchard Road**
**Armonk, N.Y. 10504(US)**

(72) Inventor: **Eggenberger, John Scott**
**984 Coeur D'Alene Way**
**Sunnyvale California 94087(US)**
Inventor: **Turner, David Price**
**110 Cherrystone Ct.**
**Los Gatos California 95030(US)**

(74) Representative: **Atchley, Martin John Waldegrave**
**IBM United Kingdom Limited Intellectual Property Department Hursley Park**
**Winchester Hampshire SO21 2JN(GB)**

(54) **Apparatus and method for decoding a sequence of pseudo-ternary digital signals.**

(57) The present invention relates to apparatus for decoding a sequence of pseudo-ternary digital signals (100), wherein each signal can have one of three possible values, a zero value, a positive value or a negative value. The apparatus is of the type which comprises storage means (116) for storing an estimator (E) representing each of the possible positive and negative values, sampling means (102) for sampling the sequence of signals (100) at predetermined time intervals and obtaining sample signals - (S), and comparison means (94, 112) for comparing each sample signal (S) with the estimator (E) to determine whether each sample signal (S) is equivalent to any one of the possible values.

Apparatus in accordance with the invention is characterised in that the comparison means comprises estimator changing means (114) for changing the current amplitude of the estimator (E) to the amplitude of a sample signal (S) when the amplitude of the sample signal appears to represent one of the possible positive or negative values more accurately than the current amplitude of the estimator.

The invention also relates to a method of decoding a sequence of pseudo-ternary digital signals, wherein each signal can have one of three possible values, a zero value, a positive value or a negative value, utilising apparatus as defined above.

Fig. 4

## APPARATUS AND METHOD FOR DECODING A SEQUENCE OF PSEUDO-TERNARY DIGITAL SIGNALS

The present invention relates to an apparatus and a method for decoding a sequence of psuedo-ternary digital signals. Pseudo-ternary digital signals are defined as signals having three possible nominal values which are constrained from signal to signal in a particular way.

A detection or decoding process is fundamental to the operation of communication or recording channels. A signal is received or read back which consists of a nominal signal which is dependent on the data sent or written and contamination due to noise and/or component imperfections. The detection or decoding process is the process of decoding the received or readback signal in order to be able to estimate and interpret the sent or written data.

In magnetic recording, binary data is typically encoded in an NRZI code. In the NRZI code, a "1" is encoded by reversing the polarity of the write current, while a "0" is encoded by not reversing the polarity of the write current. Thus, in the NRZI code a "1" is represented by a transition between the two magnetic states of the medium while a "0" is represented by maintaining the same state. The transitions between states can occur only at certain equally spaced positions or time instants, corresponding to certain equally-spaced clock times for constant velocity of the recording medium in the writing and reading process.

When the recorded data is read, the transitions from negative saturation to positive saturation result in pulses of one polarity, while the transitions from positive saturation to negative saturation result in pulses of the opposite polarity. Where there is no transition at an associated clock time, there is no pulse. Thus a recorded "1" is represented in the readback signal by either a positive or a negative pulse, and a recorded "0" is represented by the absence of a pulse.

Each bit of data is therefore represented by a positive pulse, a negative pulse or by no pulse, each spaced at periodic intervals. The readback signal is not ideal, however, being contaminated by noise and component imperfections. Some method is needed for the interpretation of the non-ideal signal as binary data. A straightforward method is to detect the signal by comparison with positive and negative thresholds. A "1" is detected when the signal is greater than the positive threshold or less than the negative threshold, a "0" otherwise.

The readback signal from the magnetic recording channel can include a positive pulse and a negative pulse which may or may not be separated by a zero value pulse at associated clock times. Since the pulses of one polarity represent transitions between positive and negative saturation of the medium and pulses of the other polarity represent transitions between negative and positive saturation, there cannot be two pulses of the same polarity without an intervening pulse of the opposite polarity. Thus, the polarities of the pulses representing a "1" must alternate. This alternating polarity rule which constrains the polarity of successive "1" pulses, is referred to as the pseudo-ternary constraint and a sequence of digital signals conforming to this constraint is defined as a sequence of pseudo-ternary digital signals.

The simple threshold detection discussed earlier would result in a maximum likelihood of detection if the signal were actually ternary. The pseudo-ternary constraint implies that detection in context can be used to achieve maximum likelihood of detection, which results in a lower probability of error than that which would result from simple threshold detection.

The use of maximum likelihood sequence detection of the Viterbi algorithm in connection with pseudo-ternary signalling systems has been suggested for the above application areas by H. Kobayashi, "Application of Probabalistic Decoding to Digital Magnetic Recording Systems", IBM Journal of Research and Development, Vol. 15, No. 1, January, 1971, pp. 64-74, and T. Aulin, et al, "Continuous Phase Modulation--Part II: Partial Response Signalling", IEEE Transactions of Communications, Vol. COM-29, No. 3, March, 1981, pp. 210-225. These publications also disclose some basic forms of receivers. As pointed out by Forney, the Viterbi algorithm is a solution to the problem of, given a sequence z of observations of a discrete time finite state Markov process in memory-less noise, finding state sequence x for which the $\underline{a}$ $\underline{posteriori}$ probability $p[x/z]$ is a maximum. This means that decoding is "decoding in context" in order to recover the symbols.

A Viterbi detector generates all possible symbols for a given coding that is applied to it. This detector thus reduces the number of sequences about which a detection decision must be made to a few survivor sequences. The survivor sequences are detected by means of a metric which is a measure of the likelihood that a given survivor sequence is the actual sequence. One manifestation of a metric in detecting a survivor is an unbounded number sequence if each survivor is measured absolutely.

The Viterbi algorithm thus essentially provides a systematic methodology for serializing the parallel detection implied by basic maximum likelihood. The methodology entails, at any point, a number of survivor sequences. There is one and only one of the survivor sequences for each possible sequence of future events. The survivor sequence is the most probable past sequence consistent with the future sequence. Since any past sequence is consistent with a number of future sequences, many future sequences share the same survivor sequence.

Given the survivor sequences and their associated metric at the time of the nth sample observation and the sample value, the Viterbi method permits computing the survivor sequences and corresponding metrics from the sample and metric value at the time of the n + 1 sample. However, these metrics may increase without bounds. A solution to this problem has been disclosed in EP-A-133480. This specification shows a detection process based on calculations which involve only the difference between metrics.

Even though the metrics may increase without bound with successive samples, their difference remained bounded. This increased simplicity and efficiency because less computing and storage resources were involved in the processing. Additionally, there was a reduction in the necessary circuitry. However, much computation was still required even with this simplification.

A method for maximum likelihood detection which did not require computation of metrics was described by C. M. Melas in "Three-Level to Two-Level Digital Code Conversion with Noise Immunity", IBM Technical Disclosure Bulletin, Vol. 15, No. 1, November, 1972, pp. 1924-1926. In this method threshold detection levels are adjusted to increase noise immunity while converting a three-level code into a two-level code.

The object of the present invention is to provide an improved apparatus and a method for decoding a sequence of psuedo-ternary digital signals.

The present invention relates to apparatus for decoding a sequence of pseudo-ternary digital signals, wherein each signal can have one of three possible values, a zero value, a positive value or a negative value. The apparatus is of the type which comprises storage means for storing an estimator representing each of the possible positive and negative values, sampling means for sampling the sequence of signals at predetermined time intervals and obtaining sample signals, and comparison means for comparing each sample signal with the estimator to determine whether each sample signal is equivalent to one of the possible values.

Apparatus in accordance with the invention is characterised in that the comparison means comprises estimator changing means for changing the current amplitude of the estimator to the amplitude of the sample signal when the amplitude of the sample signal appears to represent one of the possible positive or negative values more accurately than the current amplitude of the estimator.

The invention also relates to a method of decoding a sequence of pseudo-ternary digital signals, wherein each signal can have one of three possible values, a zero value, a positive value or a negative value, utilising apparatus as defined above.

The apparatus of the invention is used to implement a process for resolving ambiguous signals in a pseudo-ternary encoded sequence of signals using maximum likelihood detection as a form of context decoding. Both positive and negative pulses are present in the sequence of signals. The signal sequence is sampled at the clock times when pulses representing data could occur. The critical step is the recursive comparison between sample signals and the estimator and replacement of the estimator with a sample in certain circumstances. The replacement takes place if the amplitude of the sample signal exceeds the amplitude of the estimator by more than a specified amount. Otherwise the estimator is confirmed as currently representing one of the possible positive and negative values of the signal. Detection of a positive transistion of one polarity changes the mode of the process into searching for an opposite polarity transition.

The detection and decoding process comprises searching for a positive sample signal or searching for a negative sample signal, either of which represent a "1". When searching for a positive "1", the most positive sample signal is stored as the most likely "1" and is confirmed as a "1" by observation of the next sample signal which is less than it by more than a nominal amplitude. When a positive "1" has been detected the search for a negative "1" begins, and the most negative sample signal is stored as the next most likely "1". This stored value is confirmed by observation of the next sample signal which is greater than this most likely "1" by more than a nominal amplitude. The search for a positive "1" begins again when a negative "1" has been detected.

In order that the invention may be more readily understoot, an embodiment will now be described with reference to the accompanying drawings, in which:-

Fig. 1 is a flow chart representation of detection or decoding process according to the present invention,

Fig. 2 is a graphical representation of the relationship between the amplitude of a sample signal and an estimator of a positive "1" in the detection process of Fig. 1,

Fig. 3 shows a graphical representation of the relationship between the amplitudes of a sample signal and an estimator of a negative "1" in the detection process of Fig. 1, and

Fig. 4 illustrates apparatus embodying a detection or decoding system in accordance with the present invention.

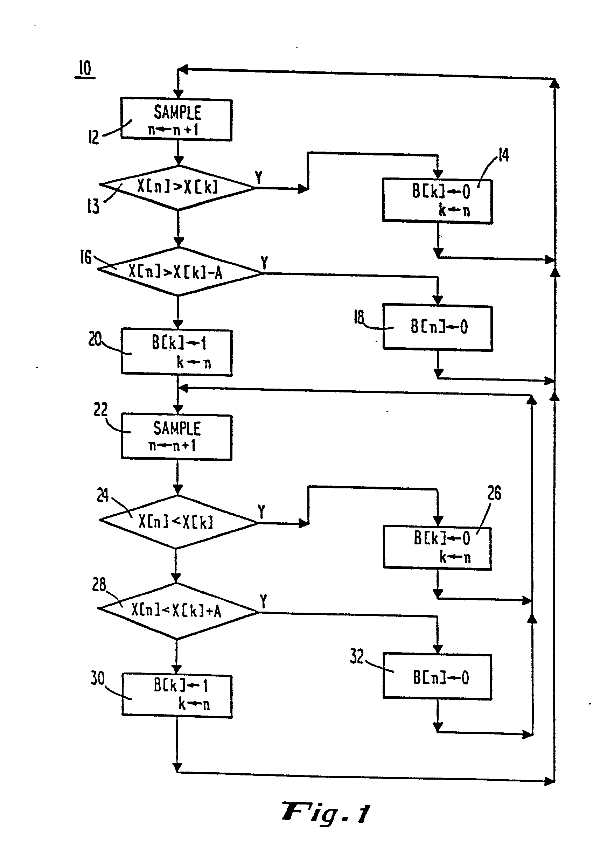

Fig. 1 illustrates a maximum likelihood detection or decoding process 10 which may be used to minimise the probability of error in transmitting data in a communication or recording device channel. Process 10 is applied to signals based on an original sequence of pseudo-ternary symbols $a_n$ = (+1,0,-1) in which n is an integer time index and a (+1) may not appear twice without an intervening (-1) and a (-1) may not appear twice without an intervening (+1).

Description of Maximum Likelihood Detection Process

The maximum likelihood detection process 10 is always in one of two modes of searching samples. In mode one, the signal in the communication or recording device channel, represented by the symbol $a_n$, is searched for a positive sample; in mode two, the signal is searched for a negative sample. In mode one, the most positive sample of the signal is used as an estimator of a positive "1" and is recorded as the most likely "1". The estimator is then compared with samples which follow it and is confirmed as a "1" by observation of a sample which is less than it by more than the magnitude of a nominal amplitude.

The nominal amplitude has approximately the magnitude which a positive "1" or a negative "1" should have under ideal channel conditions. In actual practice it is determined by adjusting the gain control of the channel by automatic gain control techniques well known in the art. Thus, a sample must be less than the estimator by a sufficient amount to permit the conclusion that the estimator is a positive "1".

The confirmation of the estimator as the most likely "1" while searching for a positive "1" changes the mode of process 10 to searching for a negative "1". In mode two, the amplitude of the most negative sample is used as an estimator and is recorded as the most likely "1", where the most likely "1" is now understood to mean the sample with the largest negative amplitude. Confirmation of the estimator as a negative "1" is by observation of a sample which is less negative than the most likely "1" by more than the nominal amplitude. The confirmation that the estimator is a negative "1" changes the mode back to searching for a positive "1" (i.e., mode one). Thus, process 10 is a recursive method which searches in one polarity, switches to the opposite polarity, and switches back again in a cyclic manner as successive estimators are each confirmed as an "1".

Searching for a Positive "1"

Referring again to Fig. 1, n represents the time index of present sample, where the present sample is defined to be the sample which is currently being decoded. The index of the sample which is currently the most likely "1" is indicated as k, where the most likely "1" is defined as the most positive sample of the output channel of the recording device channel which has been processed by process 10 during the current search for a positive "1". The magnitude of a nominal "1" sample is denoted as A. In general, samples decoded by process 10 may have either a negative or a positive amplitude depending on whether the signal received from the readback channel has a voltage level which is above or below the "0" level. All samples have a positive magnitude which is defined as the absolute value of the amplitude.

Samples of the signal which is to be decoded are produced in a conventional manner and provided to process 10 by an analog-to-digital converter (not shown). In block 12 of Fig. 1, as new sample n+1 replaces sample n, it becomes the current sample.

The operator X[i] shown in diamond 13 determines the amplitude of the ith sample. Thus, in diamond 13 a determination is made whether the amplitude of the nth sample, X[n], is larger than the amplitude of the most likely "1", X[k], in which k is the index of the most likely "1" as previously sampled. If the amplitude of current sample, n, is larger than previous sample k, the bit with time index k is assigned a value of "0". The sample n, which now appears to be the most likely "1", is selected to replace the previous sample k and is thereby designated as the new most likely "1".

The recoding of the previous most likely "1" as a "0" is shown in block 14, in which the operator B[i] denotes the ith data bit and a "0" is assigned to the bit B[k] by the operation B[k]←0. In the assignment k←n, also shown in block 14, the index of the present sample, n, becomes the index of the most likely "1", k, because the present sample was larger than the previous most likely "1". Thus, the value of the index n is assigned as the index of the estimator representing the most likely "1" and the index of the previous most likely "1", k, is revised, causing the present sample to become the new most likely "1". From block 14 process 10 returns to block 12 to process a new sample, n+1.

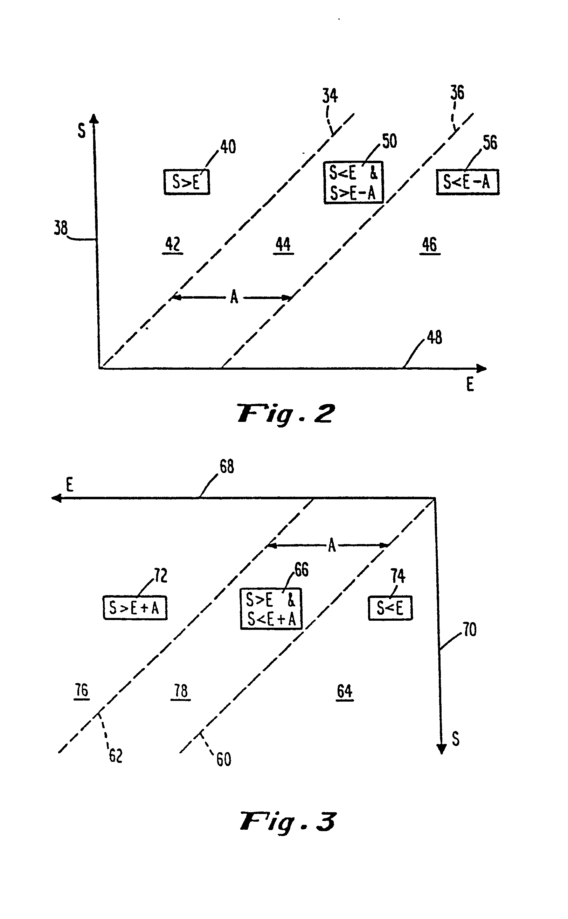

The operations performed by process 10 in diamond 13 and block 14 are shown graphically in Fig. 2. Fig. 2 shows a graph in which the amplitude of samples S on axis 38 are compared with estimators E on axis 48. Each sample will fall into one of three regions 42, 44, 46 depending on the result of the associated comparison. Dotted line 34 represents the equation S = E. Dotted line 34 and axis 38 form the boundary of region 42 in which is located each sample S which is larger than the estimator E as indicated in block 40. As described above, when a sample S is greater than the estimator E, the sample's amplitude falls in region 42, and the index of the estimator is revised and the estimator is replaced as described above referring to block 14.

If the current sample S is not larger than the most likely "1" as represented by the estimator E, a determination is made in diamond 16 whether the current sample S is larger than the most likely "1" as represented by the estimator E minus a nominal value A. If the answer is yes, the sample is not large enough to displace the estimator but is not smaller than the estimator by a sufficient amount to confirm the estimator as being the most likely "1". Further, since the sample S is not less than the estimator E by more than A, the current sample cannot be a negative "1". Since there cannot be two positive "1"'s in direct succession, the current sample is therefore determined to be a "0". Therefore, a "0" is assigned to the nth sample bit B[n] by the operation B[n]←0 as shown in block 18, and process 10 has performed a form of context decoding.

In Fig. 2, dotted lines 34, 36 define region 44 in which the estimator E is greater than the sample S and the sample S is larger than the estimator E minus the nominal sample amplitude A, as shown in block 50. Dotted line 36 represents the equation S = E-A. As previously described, each sample with a magnitude falling within region 44 in determined to be a "0".

If the nth sample is less than the most likely "1" minus the nominal amplitude A, the estimator E representing the most likely "1", B[k] is confirmed as a "1". Thus, a sample corresponds to a data bit "1" if and only if: 1) the sample is confirmed as a "1" by a subsequent sample having a sufficiently large amplitude difference, and 2) none of the intervening samples between the most likely sample and the confirming sample represent a more likely "1". Therefore, in block 20, the value "1" is assigned to the bit whose index is k, namely, the estimator or the most likely "1".

The region of Fig. 2 which corresponds to the operations of block 20 is region 46. The boundaries of region 46 are defined by axis 48 and dotted line 36 which represents the equation S = E-A. When a sample S falls in region 46, it is determined to be sufficiently below the estimator E that the estimator E is confirmed as a positive "1".

Searching for a Negative "1"

In a procedure essentially symmetrical to the procedure described thus far, process 10 searches for the most likely negative "1" following confirmation of a positive "1". The starting value of the estimator's amplitude is the magnitude of the sample which confirmed the estimator as being the most likely positive "1". This sample is sample n. Thus, in block 20, the estimator E having the index k is assigned the value of sample index n. The new most likely "1" represented by the estimator is the most recent non-zero symbol and is taken to be the sample whose amplitude is most likely to represent a negative "1".

In block 22, current sample, n, is taken and a determination is made in diamond 24 whether the amplitude of the sample n is less than the amplitude the estimator, X[k], where k is the index of the sample which previously confirmed the estimator as being the positive "1". The sample S and the estimator E are understood to have negative amplitudes, a sample S with an amplitude more negative than the amplitude of the estimator E is understood to have a greater negative magnitude than the negative magnitude of the estimator E. If the amplitude of the new sample S is more negative than the amplitude of the estimator E, the bit corresponding to the kth sample (the estimator E) is assigned a "0" by the operation B[k]←0. This is because the most previous estimator E which was considered to be the most likely "1" is interpreted as a "0" and current sample n becomes the new estimator considered to be the most likely "1". This is performed by the operation k←n as shown in block 26.

The operations of block 26 are performed when the amplitude of the current sample S falls in region 64 of Fig. 3. Each sample S will fall into one of three possible regions, namely, region 64, 78 or 76 while process 10 is searching for a negative "1". Dotted line 60, representing the equation S = E, defines one boundary of region 64 in which S is less than E as shown in block 74. A sample which falls in region 64 is more negative than the current estimator. This sample S must, therefore, become the estimator E as shown in block 26 in which k is assigned the value of n thereby revising the index of the estimator E. Process 10 then returns to block 22 to process a new sample.

If the amplitude of the current sample S is less negative than the amplitude of the estimator E as indicated by a NO answer to the decision of diamond 24, then a determination is made in diamond 28 whether the amplitude of the new sample is less than the amplitude of the estimator E plus a nominal amount A. As previously described, for block 18, if the current sample S does not differ from the estimator E representing the most likely "1" by a sufficient amount, i.e., the nominal signal amplitude A, the data bit corresponding to the current sample S is assigned a "0" by the operation B[n]←0 as shown in block 32.

A sample S which is less negative than the estimator E representing the most likely "1" but differs from it by less than the nominal sample amplitude A falls within region 78 as shown in block 66. Region 78 is bounded by dotted line 60 and by dotted line 62. Dotted line 62 represents the equation $S = E + A$. Samples which fall in region 78 are decoded as "0".

If the current sample S differs from the estimator E by more than A, the current sample S confirms the estimator E as representing a negative "1". This sample S falls in region 76 as shown in block 72. Its amplitude is separated from line 60 by at least the magnitude A and, therefore, confirms the estimator E as representing a negative "1".

After confirmation of the estimator E in diamond 28 and block 30, process 10 again switches mode by returning to block 12 to begin a new cycle by searching for the most likely positive "1". The absolute magnitude of the sample which confirmed the estimator E as representing the most likely negative "1" is used as the starting estimator E in the search for a positive "1". The value of the index of the current sample n is assigned to the index of the estimator E representing the most likely "1" by the operation k←n as shown in block 30.

Maximum Likelihood Detector System

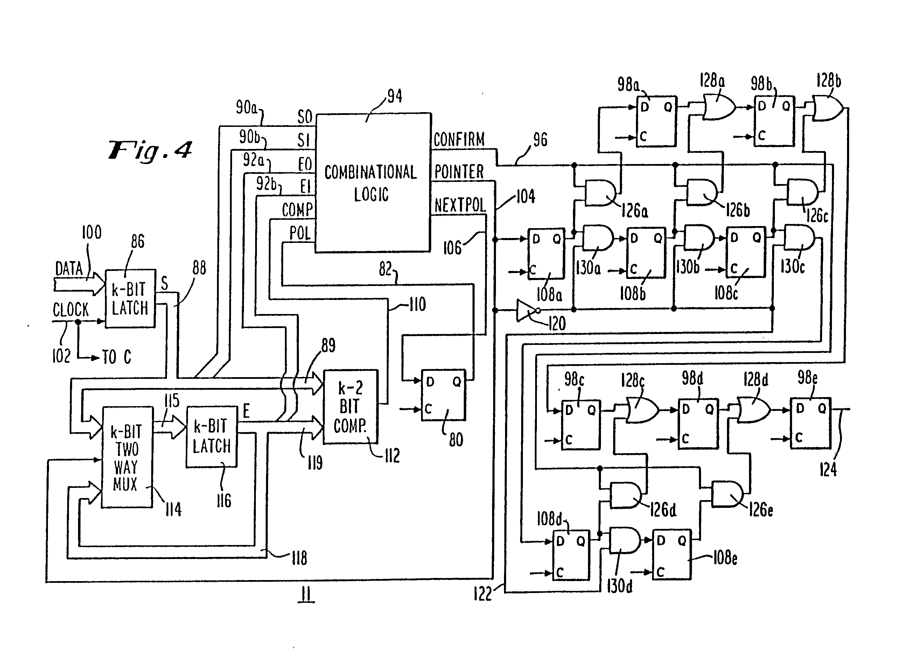

Fig. 4 illustrates a maximum likelihood detector system 11 for performing the steps of process 10. Detector system 11 includes an input data bus 100 which receives data from a conventional analog-to-digital converter (not shown). The converted signal is scaled so that the magnitude of a nominal "1" sample is equal to the weight of the second most significant digit thereof. For purposes of this specification, converted signals are assumed to be in offset binary.

Periodic samples of an original pseudo-ternary output signal from a communication or recording channel (not shown) are received by the analog-to-digital converter and applied to k-bit latch 86 via input bus 100 in a parallel, six bit, binary form. In the preferred embodiment, $k = 6$ and data bus 100 is six bits wide. Latch 86 thus receives six bits of sample information at each clock sample occurrence on clock line 102. Six bits provide near optimal resolution, since using fewer than six bits does not result in adequate resolution, and using more than six bits does not significantly improve resolution. Clock line 102 also clocks all sequential circuitry to synchronize overall operation of detector system 11.

The output of latch 86, which is applied to sample bus 88, is the sample S for interpretation by detector system 11. Sample bus 88 is six bits wide which is subsequently divided into bus 89 for receiving four bits, and lines 90a,b for receiving one bit each. Line 90a carries the high order bit, S0, of sample bus 88 and line 90b carries the second highest order bit, S1, of sample bus 88. Lines 90a,b, respectively, apply the two highest order bits of sample bus 88 to combinational logic 94. The remaining four low order bits of sample bus 88 are applied by bus 89 to k-2 bit magnitude comparator 112.

k-bit latch 116 stores a six bit binary representation of the magnitude of the estimator E. This estimator E is the value which is recorded as the current most likely "1". The output of latch 116 is six bit estimator bus 118. The four low order bits of estimator bus 118 are applied by bus 119 to k-2 bit magnitude comparator 112. The two high order bits of estimator bus 118 are applied to combinational logic 94 by lines 92a,b. Line 92a applies the high order bit, E0, of estimator bus 118 to combinational logic 94 and line 92b applies the second highest order bit, E1, to combinational logic 94. As later described, combinational logic 94 determines whether a new sample S should become an estimator E, whether a most likely "1" should be confirmed as a true "1", and whether process 10 should switch from one search mode to the other according to the decisions of diamonds 13, 16, 24 and 28 of Fig. 1. Combinational logic 94 is fully described and specified by Table I of this specification (see below).

Any steps of process 10 which may be completed by comparing the two high order bits only of the sample S with those of the estimator E are resolved by combinational logic 94 on the basis of the bit patterns on lines 90a,b and lines 92a,b. For example, in searching for a positive 1, if S0 and S1 are 11 and E0 and E1 are 10, 01 or 00, combinational logic 94 can make the determination that the sample S is greater than the estimator E as shown in diamond 13 of Fig. 1 and that the sample falls within region 42. Since the two high order bits of sample bus 88, S0 and S1, have a greater magnitude than the two high order bits, E0 and E1, of the estimator bus 118, the new sample S is greater than the estimator E regardless of the value of the four low order bits. Likewise, if lines 90a,b, which carry S0 and S1 respectively, are 10 and lines 92a,b, which carry E0 and E1 respectively, are 01 or 00, combinational logic 94 can determine that the sample S is greater than the estimator E.

However, if the high order bits of sample bus 88 and estimator bus 118 are equal, i.e., lines 90a,b and lines 92a,b and lines 92a,b apply the same bit pattern to combinational logic 94, then combinational logic 94 requires information from the four low order bits of sample bus 88 and the four low order bits of estimator bus 118 to determine whether the sample S is greater than the estimator E. Magnitude comparator 112 compares the four low order bits of sample bus 88, which are applied to comparator 112 on bus 89, with the four low order bits of estimator bus 118, which are applied to comparator 112 by bus 119.

When the magnitude represented by the bit pattern on bus 89, the low order bits of the sample S, is greater than the magnitude represented by the bit pattern on bus 119, the low order bits of the estimator E, line 110 goes high. Line 110 going high indicates that the four low order bits of the sample S are greater than the four low order bits of the estimator E. Line 110 is applied to combinational logic 94 and is used by combinational logic 94 to make the determination of diamond 13, of Fig. 1 when the bit pattern on lines 90a,b is identical to the bit pattern on lines 92a,b.

Additionally, the state of line 110 may be used by combinational logic 94 to determine whether the difference between the magnitudes of the sample S and estimator E is greater than the nominal sample amplitude, A, when the magnitude of the sample S does not exceed the magnitude of the estimator E. From this determination, it is known whether the sample falls within region 44 or region 46 (see Fig. 2) while process 10 is searching for the most likely positive "1" and whether the sample S falls within region 76 or region 78 (see Fig. 3) while process 10 is searching for the most likely negative "1".

To implement all the determinations of process 10 in the most straightforward manner requires a subtraction, an addition, and three magnitude comparisons because it must be determined whether the sample S varies from the estimator E by more than the nominal amplitude A. The propagation delays of such adders, subtractors and additional comparators slow down the execution of process 10. However, in a digital implementation, scaling can be used for relative magnitude comparison to reduce the complexity of the required calculations. As stated earlier in this specification, the input to detector system 11 is scaled such that the nominal amplitude, A, is equal to the weight of the second most significant bit in the binary representations of the sample S and the estimator E. This scaling may be accomplished by conventional automatic gain control.

Since the second most significant bit is selected to be the nominal amplitude, a 100% overrange capability for the analog-to-digital conversion is provided. Thus, if it is known that the weight of S1 and E1, the second most significant bit of the sample S and the estimator E respectively, represents the magnitude, A, the relative magnitude comparison of diamond 16 may be implemented by combinational logic 94 without the propagation delay caused by adders and subtractors.

For example, if S0 and S1 are 01 and E0 and E1 are 11, it is not only known that the estimator E is greater than the sample S, but it is also known that the estimator E is greater than the sample S by more than the nominal amplitude A. Thus, if S0 and S1 are subtracted from E0 and E1, the equation 11 -01 = 10 results. This resultant value 10 exceeds the 01 value which represents the scaled magnitude of A. Thus, the difference between the sample S, and the estimator E exceeds the nominal amplitude A. This determination may be made using combinational logic 94 only without reference to line 110 from magnitude comparator 112.

However, the state of line 110 is necessary to resolve the determination of diamond 16 of Fig. 1 when the high order sample bits are equal to the high order estimator bits and when the estimator bits exceed the sample bits by a difference of 01. For example, if S0 and S1 are 10 and E0 and E1 are 11, it may be determined on the basis of lines 90a,b and 92a,b alone that the estimator E is greater than the sample S, since 11 -10 = 01.

However, it cannot be determined from the information on lines 90a,b and 92a,b whether the estimator E exceeds the sample S by more than the nominal sample amplitude A. Obviously, the full six bit value of the estimator E may range from 110000 to 111111 when E0 and E1 are 11 and the full six bit value of the sample S may range from 100000 to 101111 when S0 and S1 are 10. The maximum possible difference between the estimator E and the sample S, a difference of 011111, occurs when the estimator E is 111111 and the sample S is 100000. The minimum possible difference, 000001, occurs then the estimator E is 110000 and the sample S is 101111.

Thus, the difference between the sample S and the estimator E may range from 000001 to 011111. The value of A, 010000, falls within this range and the difference between the sample S and the estimator E may be greater than A or less than A. Therefore, the relative magnitude of the sample S and the estimator E cannot be resolved on the basis of the high order bits alone and the signal applied by line 110 to combinational logic 94 is used to resolve the comparison.

All operations performed within combinational logic 94 are performed to determine the states of CONFIRM line 96, POINTER line 104 and NEXTPOL line 106. The states of CONFIRM line 96, POINTER line 104 and NEXTPOL 106 are shown in Table I for all states of the six input lines of combinational logic 94. Combinational logic 94 may be implemented using a conventional ROM having a capacity of at least sixty-four words with a length of three bits. Also, as indicated earlier in this specification, combinational logic 94 may be implemented using random logic according to Table I.

POINTER line 104 goes high when a new sample S on sample bus 88 is greater than the estimator E which is stored in latch 116. POINTER line 104 is applied to k-bit multiplexer 114. When POINTER line 104 is high, k-bit multiplexer 114 causes the data on sample bus 88 to appear on bus 115. Bus 115 applies this data to k-bit latch 116. The output of latch 116 forms six bit estimator bus 118, the four low order bits of which are applied to bit magnitude comparator 112 and the two high order bits of which are applied to combinational logic 94 as previously described. Thus, the current sample S on sample bus 88, is latched into latch 116 when POINTER line 104 is high, thereby becoming the estimator, and operation k←n of block 14 is implemented.

When the sample S is not greater than the estimator E, POINTER line 104 is low, causing two-way multiplexer 114 to select estimator bus 118 to be applied to latch 116 rather than sample bus 88. When POINTER line 104 is low, the output of latch 116 is fed, through estimator bus 118 and multiplexer 114, back to the input of latch 116, thereby maintaining the current value of the estimator. Thus, multiplexer 114, under the control of POINTER line 104, determines whether the sample S or the current estimator E is stored in latch 116 during the nth clock cycle. Selecting a new value for the estimator or maintaining the current value for the estimator depends on whether or not the current sample S is greater than the estimator E, as described above in connection with Figs. 1, 2 and 3.

Additionally, when POINTER line 104 is high, input D of latch 108a is high. Inverter 120 inverts the signal level on POINTER line 104 and applies the inverted POINTER line 104 signal on line 122 to latches 108b-e through AND gates 130a-d. This action causes a "0" to be entered into latches 108b-e when the "1" is entered into latch 108a. Thus, all latches 108a-e are reset except for latch 108a when POINTER line 104 goes high. The "1" which is entered into 108a shifts through latches 103b-e during successive clock cycles. It thus marks the bit position of the current most likely "1" and latches 108a-e serve as a shift register containing a single "1" which points to the bit position of the most likely "1". This bit position corresponds to bit k.

If, for example, two samples later a new sample exceeds the present most likely "1", the "1" in latch 108a will have shifted to latch 108c. POINTER line 104 again goes high causing a new "1" to be latched into latch 108a. The "1" which corresponded to the previous most likely "1", i.e., the "1" which is latched into latch 108c, is not shifted to latch 103d because the "0" on line 122 is applied to AND gate 130c causing latch 130d to receive a "0". This zeroing of the previous most likely "1" implements the operation B[k]←0 of block 16 of Fig. 1. Thus, the index of the most recent non-zero input signal is revised by latching a "1" from POINTER line 104 into latch 108a at a different bit position.

Each latch 108a-e points to a corresponding latch 98a-e through AND gates 126a-e. For example, latch 108a points to latch 98a through AND gate 126a and latch 108d points to latch 98d through AND gate 126d. Thus, latches 108a-d are pointer latches in which each latch 108a-d except one stores a "0". When a most likely "1" is confirmed as a true "1", for example, as determined in diamond 16, CONFIRM line 96 goes high. CONFIRM line 96 is applied to AND gates 126a-e. The outputs of pointer latches 108a-e respectively, are also applied to AND gates 126a-e as previously described. A high level on CONFIRM line 96 causes AND gates 126a-e to gate the contents of each latch 108a-e into its corresponding latch 98a-e.

Because latches 108a-e contain "0" in all locations except the location corresponding to the bit position of the most likely "1", a single "1" is transferred to latches 98a-e through AND gates 126a-e. This single "1" is the "1" which was confirmed in combinational logic 94 causing CONFIRM line 96 to go high. OR gates 128a-d allow previously confirmed "1"'s to continue shifting through latches 98a-e when "0"'s from latches 108a-d are gated through AND gates 126a-e to latches 98a-e by a high level on CONFIRM line 96.

After combinational logic 94 confirms a most likely "1" and gates the contents of latches 103a-e through to latches 98a-e, detector system 11 switches mode and begins searching for a "1" of the opposite polarity. NEXTPOL line 106, which indicates that the polarity of the next mode is to be searched, therefore, goes high and toggles latch 80 causing latch 80 to change state. The output of latch 80 is applied by line 82 to combinational logic 94 to indicate the change in polarity. The use of a separate latch 80 for toggling the polarity allows the logic within logic 94 to be purely combinational.

When NEXTPOL line 106 causes latch 80 to indicate to combinational logic 94 that process 10 is searching for a negative "1", the logic of diamonds 24 and 28 is performed within combinational logic 94 rather than the logic of diamonds 13 and 16. When searching for a negative "1" combinational logic 94 uses the two high order bits of sample bus 88, the two high order bits of estimator bus 118, and line 110 from comparator 112 as previously described. When POINTER line 104 goes high indicating that a current sample S is the most likely "1" and when CONFIRM line 96 goes high gating the contents of latches 108a-d into latches 98a-d, also as previously described, a single binary "1" is transferred to one of the latches 98a-d. Thus, all samples representing $a_n = +1$ or $a_n = -1$ are decoded as binary "1" by detector system 11 and all remaining samples are decoded as binary "0". The binary output of detector system 11 appears at output line 124.

In considering the length of the shift registers formed by latches 108a-e and by latches 98a-e required for detector system 11 to implement process 10, it can be seen that a most likely "1" in latches 108a-e which represents a true "1" must be confirmed and gated to latches 98a-d before it is shifted through latches 108a-e. Therefore, the shift registers must be of sufficient length that a pointer representing a true "1" does not reach the end until it is confirmed. The number of latches in the shift registers must be one more than the maximum run length of "0"'s in the input data. Thus, the shift register length is determined by maximum run length of "0"'s of the pseudo-ternary code which is applied to detector system 11. This run length constraint must be applied to ensure correct detection with a finite length shift register.

TABLE I

```
POL      0 0 0 0 0 0 0 0 0 0 0 0 0 0 0 0 0 0 0 0 0 0 0 0 0 0 0 0 0 0 0 0

SO       0 0 0 0 0 0 0 0 0 0 0 0 0 0 0 0 1 1 1 1 1 1 1 1 1 1 1 1 1 1 1 1

S1       0 0 0 0 0 0 0 0 1 1 1 1 1 1 1 1 0 0 0 0 0 0 0 0 1 1 1 1 1 1 1 1

EO       0 0 0 0 1 1 1 1 0 0 0 0 1 1 1 1 0 0 0 0 1 1 1 1 0 0 0 0 1 1 1 1

E1       0 0 1 1 0 0 1 1 0 0 1 1 0 0 1 1 0 0 1 1 0 0 1 1 0 0 1 1 0 0 1 1

COMP     0 1 0 1 0 1 0 1 0 1 0 1 0 1 0 1 0 1 0 1 0 1 0 1 0 1 0 1 0 1 0 1
```
---
```
CONFIRM  0 0 0 0 0 0 0 0 1 0 0 0 0 0 0 0 1 1 0 1 0 0 0 0 1 1 1 1 0 1 0 0

POINTER  1 0 1 1 1 1 1 0 1 1 0 1 1 1 1 1 0 1 1 0 1 1 1 1 1 0 1 1 0 1 1 0

NEXTPOL  0 0 0 0 0 0 0 0 1 0 0 0 0 0 0 0 1 1 0 1 0 0 0 0 1 1 1 1 0 1 0 0
```

```
POL      1 1 1 1 1 1 1 1 1 1 1 1 1 1 1 1 1 1 1 1 1 1 1 1 1 1 1 1 1 1 1 1

SO       0 0 0 0 0 0 0 0 0 0 0 0 0 0 0 0 1 1 1 1 1 1 1 1 1 1 1 1 1 1 1 1

S1       0 0 0 0 0 0 0 0 1 1 1 1 1 1 1 1 0 0 0 0 0 0 0 0 1 1 1 1 1 1 1 1

EO       0 0 0 0 1 1 1 1 0 0 0 0 1 1 1 1 0 0 0 0 1 1 1 1 0 0 0 0 1 1 1 1

E1       0 0 1 1 0 0 1 1 0 0 1 1 0 0 1 1 0 0 1 1 0 0 1 1 0 0 1 1 0 0 1 1

COMP     0 1 0 1 0 1 0 1 0 1 0 1 0 1 0 1 0 1 0 1 0 1 0 1 0 1 0 1 0 1 0 1
```
---
```
CONFIRM  0 0 1 0 1 1 1 0 0 0 0 1 0 1 1 0 0 0 0 0 0 1 0 0 0 0 0 0 0 0 0 0

POINTER  0 1 1 0 1 1 1 1 1 0 1 1 0 1 1 1 1 1 0 1 1 0 1 1 1 1 1 0 1 1 0 1

NEXTPOL  1 1 0 1 0 0 0 0 1 1 1 1 0 1 0 0 1 1 1 1 1 1 0 1 1 1 1 1 1 1 1 1
```

## Claims

1. Apparatus for decoding a sequence of pseudo-ternary digital signals (100), wherein each signal can have one of three possible values, a zero value, a positive value or a negative value, comprising

storage means (116) for storing an estimator (E) representing each of said possible positive and negative values,

sampling means (102) for sampling said sequence of signals (100) at predetermined time intervals and obtaining sample signals (S), and

comparison means (94, 112) for comparing each sample signal (S) with said estimator (E) to determine if each sample signal (S) is equivalent to any one of said possible values,

characterised in that

said comparison means comprises

estimator changing means (114) for changing the current amplitude of said estimator (E) to the amplitude of a sample signal (S) when the amplitude of said sample signal appears to represent one of said possible positive or negative values more accurately than the current amplitude of said estimator (E).

2. Apparatus as claimed in Claim 1, characterised in that said estimator changing means comprises

detection means for detecting that the amplitude of a sample signal (S) is greater than the current amplitude of said estimator (E), and

replacing means (114) for replacing the current amplitude of said estimator (E) with the amplitude of said sample signal (S).

3. Apparatus as claimed in Claim 2 characterised in that said comparison means comprises means for interpreting the current amplitude of said estimator (E) as representing a zero value signal in said sequence.

4. Apparatus as claimed in any one of the preceding claims, characterised in that said comparison means comprises detection means for detecting that the amplitude of a sample signal (S) is less than the current amplitude of said estimator - (E), and means, responsive to the output of said detection means, for confirming that said estimator (E) represents one of said possible positive or negative values.

5. Apparatus as claimed in any one of the preceding claims, characterised in that said comparison means comprises additional detection means for detecting that the amplitude of a sample signal (S) is less than the current amplitude of said estimator (E) by more than a predetermined amount (A), and means, responsive to the output of said additional detecting means, for identifying said sample signal (S) as repesenting a zero value signal in said sequence.

6. Apparatus as claimed in any one of the preceding claims characterised in that

said comparison means operates in two alternative modes, a first mode in which it detects sample signals (S) which are equivalent to said possible positive value and a second mode in which it detects sample signals (S) which are equivalent to said possible negative signals,

and in that

said apparatus comprises switch means (80) for switching said comparison means from said first mode of operation into said second mode of operation when it has detected a sample signal (S) equivalent to said possible positive value, and from said second mode of operation into said first mode of operation when it has detected a sample signal - (S) equivalent to said possible negative value.

7. A method of decoding a sequence of pseudo-ternary digital signals (100), wherein each signal can have one of three possible values, a zero value, a positive value or a negative value, comprising

storing an estimator (E) representing each of said possible positive and negative values,

sampling said sequence of signals at predetermined time intervals and obtaining sample signals - (S), and

comparing each sample signal (S) with said estimator (E) to determine if each sample signal (S) is equivalent to any one of said possible values,

characterised in that

said comparison operation comprises

changing the current amplitude of said estimator - (E) to the amplitude of a sample signal (S) when the amplitude of said sample signal (S) appears to represent one of said possible positive or negative values more accurately than the current amplitude of said estimator (E).

8. A method as claimed in Claim 7, characterised in that said estimator changing operation comprises

detecting that the amplitude of a sample signal (S) is greater than the current amplitude of said estimator (E), and

replacing the current amplitude of said estimator - (E) with the amplitude of said sample signal (S).

9. A method as claimed in Claim 8 characterised in that

said comparison operation comprises interpreting the current amplitude of said estimator (E) as representing a zero value signal in said sequence.

10. A method as claimed in any one of claims 7, 8 or 9, characterised in that said comparison operation comprises detecting that the amplitude of a sample signal (S) is less than the current amplitude of said estimator (E), and, in response to the result of this detection operation, confirming that said estimator (E) represents one of said possible positive or negative signals.

11. A method as claimed in any one claims 7, 8, 9, 10. 11 or 12, characterised in that said comparison operation comprises additionally detecting that the amplitude of a sample signal (S) is less than the amplitude of said estimator (E) by more than a predetermined amount (A), and, in response to the result of this additional detection operation, identifying said sample signal (S) as repesenting a zero value signal in said sequence.

12. A method as claimed in any one of claims 7, 8, 9, 10, or 11 characterised in that said comparison operation

operates in two alternative modes of operation, a first mode in which it results in the detection of sample signals (S) which are equivalent to said possible positive value and a second mode in which it results in the detection of sample signals - (S) which are equivalent to said possible negative signals, and

switches from said first mode of operation into said second mode of operation when it has resulted in the detection of a sample signal (S) equivalent to said possible positive value, and from said second mode of operation into said first mode of operation when it has resulted in the detection of a sample signal (S) equivalent to said possible negative value.

*Fig.1*

**Fig. 2**

**Fig. 3**

Fig. 4